# EUROPEAN PATENT SPECIFICATION

(11) **EP 2 122 393 B1**
(45) Date of publication and mention of the grant of the patent: **03.04.2013**
(21) Application number: 08707756.6
(22) Date of filing: 18.02.2008
(51) Int. Cl.: G02B 5/09, G03F 7/20, G02B 7/18

(54) **METHOD FOR PRODUCING FACET MIRRORS AND PROJECTION EXPOSURE APPARATUS**
VERFAHREN ZUR HERSTELLUNG VON FACETTENSPIEGELN UND PROJEKTIONSBELICHTUNGSVORRICHTUNG
PROCÉDÉ DE PRODUCTION DE MIROIRS À FACETTES ET APPAREIL D'EXPOSITION PAR PROJECTION

(30) Priority: 19.02.2007 DE 102007008448
(43) Date of publication of application: 25.11.2009
(73) Proprietor: Carl Zeiss SMT GmbH, 73447 Oberkochen (DE)
(72) Inventor: WARM, Berndt, 90571 Schwaig (DE); RENNON, Sigfried, 97084 Würtzburg (DE); DINGER, Udo, 73447 Oberkochen (DE); BAIER, Jürgen, 73447 Oberkochen (DE); BURKART, Stefan, 89522 Heidenheim (DE); KOUROUKLIS, Christos, 71701 Schwieberdingen (DE); CHUNG, Hin Yiu Anthony, 89275 Elchingen (DE); WIESNER, Stefan, 73466 Lauchheim (DE); ENKISCH, Hartmut, 73431 Aalen (DE); DENGEL, Günther, 89518 Heidenheim (DE)
(74) Representative: Raunecker, Klaus Peter
(86) International application number: PCT/EP2008/001247
(87) International publication number: WO 2008/101656

(56) References cited:
- EP-A- 0 955 565
- EP-A- 1 296 162
- WO-A-03/050586
- WO-A-03/067288
- WO-A-2004/066010
- WO-A-2005/006081
- US-A- 5 975 709

## Description

The invention relates to facets for a facet mirror and to facet mirrors, and to projection exposure apparatuses in semiconductor lithography. Facet mirrors of this type are used in particular for producing specific spatial illumination distributions in illumination systems for EUV projection exposure apparatuses at a working wavelength of 13 nm.

In this case, the illumination system must not only shape and uniformly illuminate the object field of a projection objective but also shape the pupil of the projection objective and, whilst complying with fixed pupil positions, fill it with light as uniformly as possible. The pupil filling can vary depending on the application. Thus, generally so-called conventional, i.e. more or less complete, and also annular or even more general multipole fillings of the pupil have to be provided as rapidly as possible and in a manner as free from losses as possible.

The image field generally has a rectangular shape, and EUVL exposure apparatuses generally use an annular object field having a high aspect ratio (typically 104×8mm²).

While in VUV systems for 248 nm and 193 nm field and pupil can be shaped highly accurately and highly variably by means of a multiplicity of diffractive, reflective and refractive elements disposed one after another, EUVL systems, owing to the comparatively low reflectivity (60-70%) of the mirrors, have to fulfill this task with a minimum number of mirrors.

One of the main problems of EUV lithography is providing a sufficiently high illumination intensity. In order that the light power available only to a limited extent can be utilized as optimally as possible, the development of EUVL illumination systems is therefore aimed at continually reducing the number of mirrors whilst at the same time maintaining the functionality and increasing the efficiency (usable intensity on reticle relative to the costs of generating light).

The illumination systems that are currently in development or realized are essentially based on plasma sources, preferably GDPP (gas discharge produced plasma) or LPP (laser produced plasma) sources, the light of which is initially collected as efficiently as possible by a grazing incidence or normal incidence collector. In this case, for a given source size, the collectable solid angle at the source is limited generally by the etendue of the projection objective and the partial coherence properties of the application.

In the further beam course, a two-stage reflective fly's eye condenser preshapes field and pupil from the light collected by the collector, and a reflective field optic disposed downstream ensures the optimum imaging of field and pupil into the corresponding planes of the downstream projection objective in the beam course.

Such illumination systems according to the prior art are known e.g. from US 6 438 199 B1. The field shaping takes place on a first field honeycomb plate according to the teaching of the aforementioned document. The individual field honeycombs generally have an aspect ratio or a shape that is very close to the later illumination zone on the reticle. In conventional annular field systems, the field honeycombs are therefore formed as annular or, if appropriate, rectangular field facets having an aspect ratio of typically 26:2 which together form the so-called field facet mirror. A rectangular field can be converted, if appropriate, into an annular field by means of a suitable field mirror. The field honeycomb plate is then covered with individual facets as densely as possible.

The pupil facet plate downstream of the field honeycomb plate in the beam course is situated in a conjugate plane with respect to the objective pupil of the projection objective. The so-called pupil setting, that is to say the intensity distribution in the pupil plane, therefore results from the illumination of the pupil facet plate. The pupil facet plate is likewise constructed from a multiplicity of individual mirror facets - the so-called pupil facets. If the pupil facet plate cannot be positioned directly in the entrance pupil of the projection objective, a downstream optical assembly images the pupil facet plate exactly into the entrance pupil of the projection objective. A grazing incidence folding mirror can be disposed downstream for reasons of structural space or for the curvature of an initially rectangular field.

The pupil setting, which is generally predetermined by the user, is set by the adaptation of the tilt angles of the individual field facets. By adapting the tilt angles of the individual pupil facets, the subfields corresponding to the individual channels are superposed in the reticle plane.

Essential requirements made of said mirror facets consist in exhibiting a predetermined angle of reflection with an accuracy in the range of a few tens of angular seconds, and in having a reflective surface having a surface roughness of a few angstrom. In order to enable the application of as many different illumination settings as possible, it is advantageous to use facets having an arcuate outer shape in the field facet mirror. This measure furthermore affords the advantage that the field-shaping mirror required according to the prior art could be obviated, whereby the transmission of the overall system would increase by approximately 50%. However, a major difficulty in producing arcuate mirror facets consists in the fact that a very high angular accuracy and a likewise very high surface accuracy in the sense of low surface roughness can be produced simultaneously only with very great difficulty.

The facet mirror in present-day EUVL fly's eye condensers is constructed from up to 500 individually fabricated mirror facets. The latter can be rectangular, annular or alternatively bordered. In this case, the mirror facets must have a very low surface roughness within the range of 0.1-0.2 nm rms in order to reflect the EUV light used with high reflectivity and small scattering components. The reflectivity of the mirrors is determined by the so-called "high spatial frequency roughness" HSFR, typically comprising spatial wavelengths of between 10 nm and 1 µm, while the scattered light depends on the so-called "mid spatial frequency roughness" (MSFR) having typical spatial wavelengths within the range of between 1 µm and 1 mm. In this case, the precise spatial frequency ranges depend on the position of the mirror in the optical system.

The field facets generate an image of the light source on the respectively assigned pupil facets. The optically active surface usually has a spherical shape for this purpose. If the scattered light components are too large, part of the - very expensive - light is lost through excessive radiation of the pupil facets.

This also holds true in cases where the tilt angles of the field facets deviate from their nominal values, since the associated pupil facet is then no longer impinged on centrally and part of the light spot misses the pupil facet. Typical tilt error tolerances of the field facets are therefore typically less than 0.5 mrad.

Relative to the width of the end side of the field facet, which is typically 2 mm, this means a maximum permissible tilt of 1 µm. The field facets are typically combined to form blocks of typically 10 facets. Since the tolerances hold true for the individual facets in the mounted state and side area errors cumulate, even narrower tolerances therefore routinely hold true for the individual facets.

In this case, each facet usually has individually different nominal tilt angles since the assignment to the pupil facets has stochastic components for optical reasons.

This imposes extreme requirements on the mechanical fabrication accuracy of the individual facets. Therefore, at the present time the facets are fabricated individually in high-precision polishing devices. Corresponding methods are disclosed e.g. in WO 2005/006081A1 and US 6,984,051 B2. However, the methods described in said documents are extremely time-consuming and therefore also cost-intensive and can be applied only with difficulty to annular facet geometries such as will be required in future systems for high-precision pupil filling.

In order to increase the reflectivity, the field facets are usually coated with a multilayer stack (typically 100 individual layers composed of Mo and Si alternately). In this case, the layer thickness (a few nm) of the individual layers has to be adapted to the tilt angle and be supervised in the thousandths range, i.e. in the range of a few picometers, such that the facets generally have to be coated individually or, if appropriate, in groups - this, too, is a very complicated and cost-intensive process.

While the methods described above were still acceptable for the first EUVL prototype tools having approximately 150 facets, the 500 channels of the successor systems represent a serious economic and logistic risk. The facet arrays can no longer be provided sufficiently rapidly with tenable outlay, under certain circumstances, in series fabrication. A field facet array fabricated using conventional technology could therefore become by far the most expensive component in the complete optical EUVL system.

In an attempt to avoid the problems outlined, Hashimoto et al. (JSME Series C, vol. 47, No. 3, 2004, 916pp) were indeed able to show that a complete field facet array can be produced as a monolithic block with spherical bearing areas by means of a 5-axis milling machine with acceptable mechanical accuracy. However, it was not possible in that case to obtain a sufficient surface quality adequate for the application with EUV.

A method for the series fabrication of mirror facets is described by Takino et al. (J. Microlith., Microfab., Microsyst., vol. 3 No. 3, July 2004, P. 396 ff). Said publication presents a method in which firstly the surface of a semifinished product is polished and the desired mirror facets are subsequently separated from the semifinished product. However, the mirror facets produced in this way have a reflectivity that is too low for the EUVL application, such that it is necessary to perform a multilayer coating on the individual mirror facets after the mirror facets have been separated from the semifinished product. This additional processing step generates considerable fabrication outlay that significantly reduces the economic viability of the method presented.

Moreover, DE 100 30 495 A1 describes a method in which a high-precision basic body is produced galvanically, on which the mirror facets are applied or in which the mirror facets are positioned with high precision and the basic body is grown galvanically. Particularly when using mirror facets composed of silicon, however, the method described in said document is associated with some difficulties. Thus, on account of the semiconducting properties of silicon, it is necessary firstly to subject the mirror facets to a coating process in order to make them accessible for galvanic methods. In particular, when applying the teaching described in said document, difficulties evidently arise from the handling of the already finally polished surfaces of the mirror facets in the course of arrangement with respect to the basic body.

An EUV projection exposure apparatus is disclosed in EP 1 296 162 A, EP 0 955 565 A, US 5 975 709 A.

Consequently, it is an object of the present invention to provide a method for producing mirror facets for a facet mirror which permits the economic production of mirror facets with high angular accuracy and at the same time low surface roughness; moreover, it is an object of the invention to specify projection exposure apparatuses, in particular for EUV lithography, which are equipped with mirrors having positive optical properties.

Consequently, it is an object of the present invention to provide an EUV projection exposure apparatuses comprising mirrors with high angular accuracy and at the same time low surface roughness and having positive optical properties.

This object is achieved by means of the devices having the features specified in claim 1. The subclaims relate to advantageous variants and developments of the invention.

The EUV projection exposure apparatus according to an example not forming part of the invention has a facet mirror having mirror facets arranged on carrying elements. In this case, the mirror facets have a thickness of less than 2 mm, in particular within the range of 0.2 mm-1.2 mm. The carrying elements can be a basic body common to a plurality of mirror facets or else intermediate pieces or so-called bottom facets, which, for their part, are connected to a carrier body. In this case, the small thickness of the mirror facets has the effect that the mirror facets exhibit a certain shape flexibility and are adapted within certain limits to the shape of the carrying element on which they are arranged. Possible shape deviations of the mirror facets that originate from the fabrication process can be compensated for in this way, without the optical properties, in particular the reflectivity and the surface quality of the mirror facets, being impaired thereby.

In this case, the connection of the mirror facets to the carrying elements can be realized by means of a soldering layer having a thickness within the range of 2-10 µm, in particular within the range of 3-7 µm. The thinner the soldering layer is made, the better the heat transfer between the mirror facet and the carrying element and cooling devices possibly present. Since the facet mirror is operated in a vacuum, cooling via the carrying element is of considerable importance since, otherwise, thermal energy can be dissipated to the surroundings only by way of radiation and not by way of convection.

As an alternative, the mirror facets can be connected to the carrying elements by means of an inorganic layer containing silicon oxide bridges. Such a layer can be produced by the so-called "low-temperature bonding" method. In said method, the joining partners are brought into contact using a basic solution, e.g. a KOH solution, and SiO₂, whereby said silicon oxide bridges are formed.

As an alternative, the mirror facets can also be connected to the carrying elements by means of a bonding or an adhesive layer.

The mirror facets can have a reflective surface with a multilayer, in particular composed of Mo/Si double layers.

In this case, the multilayer can have approximately 10-80, in particular 50 double layers, wherein the thickness of the Mo/Si double layer is 6.8-15nm and wherein the thickness of the Mo layer is 1,3nm-12nm; it is also conceivable for the total thickness of a double layer to vary perpendicular to the layer course of the multilayer, whereby a so-called "chirp" is realized. This reduces the angle dependence of the reflectivity of the multilayer - although to the detriment of the total reflectivity.

At least two mirror facets can be connected to a common, integral basic body, which in this case functions as a carrying element; in this case, the basic body can have differently oriented areas for receiving the mirror facets. Moreover, the connection to the basic body can be formed by means of suitably dimensioned intermediate pieces as carrying elements.

It is furthermore conceivable for all the mirror facets of the facet mirror to be arranged on a common, integral basic body.

The basic body can be composed of the same material as the uncoated mirror facet, in particular the basic body can be at least partly composed of Si.

The mirror facet can furthermore be composed of an optically polishable material, in which a surface roughness of less than 0.5 nm rms, preferably less than 0.2 nm rms, can be achieved in the high spatial frequency (HSFR) range. In this case, the carrying element can be composed of a material having a thermal conductivity of at least 100W/(mK), in particular a metallic material or SiC.

By way of example, the mirror facets can contain Si, SiO₂, NiP or NiP-coated metal or SiC.

One possibility for arranging the facet mirror in the system consists in arranging the facet mirror in the illumination system of the EUV projection exposure apparatus.

Cavities, in particular in the form of grooves, can be formed in the region between the mirror facet and the carrying element, which cavities can furthermore be connected to coolant lines.

The invention consists in an EUV projection exposure apparatus , wherein the projection exposure apparatus has at least one mirror element, arranged on a carrying element, wherein the mirror element is composed of an optically polishable material in which a surface roughness of less than 0.5 nm rms, preferably less than 0.2 nm rms, can be achieved in the high spatial frequency (HSFR) range, and in that the carrying element is composed of a material having a thermal conductivity of at least 100W/(mK), in particular a metallic material, and wherein the mirror element has a thickness within the range of 0.2-5 mm, preferably within the range of 1-3 mm, whereby cavities, in particular in the form of grooves, are formed in the region between the mirror element and the carrying element, wherein the cavities are connected to coolant lines.

In this case, the mirror element can be a mirror facet formed as part of a facet mirror arranged in the illumination system of the apparatus.

The mirror element can contain Si, in particular. As an alternative to using Si, the mirror element can also be formed as a nickel-coated steel body.

The carrying element can be arranged on a carrier body and be embodied such that it is movable, in particular tiltable, with respect to the carrier body.

The carrying element and the carrier body can be formed from the same material, in particular from a steel such as e.g. invar, thereby ensuring an improved heat transfer from the carrying element to the carrier body. This can be improved further by the carrying element and the carrier body being embodied in polished fashion in the region of their respective contact areas. Fabrication of the carrier body and/or the carrying element from Cu or A1 is likewise conceivable.

The heat transfer between the mirror element and the carrying element can be improved by the mirror element and the carrying element being connected to one another by a soldering connection; an alternative to this consists in the mirror elements being connected to the carrying elements by means of an inorganic layer containing silicon oxide bridges. Such a layer can be produced in particular by means of a low-temperature bonding method. In said method, the joining partners are brought into contact using a basic solution, e.g. a KOH solution, and SiO₂, whereby said silicon oxide bridges are formed.

A reduction of the influence of the different coefficients of thermal expansion of mirror element and carrying element can be achieved in particular by cavities, in particular in the form of grooves, being formed in the region between the mirror element and the carrying element. What is achieved in this way is that the mirror element and the carrying element are connected to one another not over the whole area, but rather via webs or pillar-like projections. In this case, said webs or projections have the effect that the deformations that arise on account of the different coefficients of thermal expansion in the arrangement do not reach, or reach only to a reduced extent, the optically active surface of the mirror element, but rather are essentially absorbed by a deformation of the webs or projections.

The cavities produced in this way can be connected to coolant lines, whereby an active cooling of the arrangement is made possible.

Furthermore, there is a possibility of forming the mirror element in wedge-shaped or spherical fashion, whereby affording e.g. a possibility of setting an angular offset beforehand as early as during production. The requirements made of tiltability with respect to the carrier body can be reduced in this way e.g. for selected mirror elements on their carrying elements.

The mirror element can be a substantially circular lamina having a diameter within the range of between 2 mm-15 mm, preferably within the range of between 8 mm-12 mm.

An alternative or else additional possibility for reducing the effect of temperature changes on the optically active surface of the mirror element can also be achieved by the mirror element and the carrying element being connected to one another by means of a connecting layer composed of a connecting material having a modulus of elasticity of < 70MPa. In this case, the connecting layer acts in the manner of an expansion joint. Particularly in combination with the cavities mentioned above, it is thus possible to achieve further improved deformation decoupling.

The mirror elements can have a reflective surface with a multilayer, in particular composed of Mo/Si double layers, wherein the multilayer has approximately 10-80, in particular 50 double layers, wherein the thickness of the Mo/Si double layer is 6.8-15nm and wherein the thickness of the Mo layer is 1,3nm-12nm.

A method not forming part of the invention for producing overall facets for a facet mirror consists in fabricating the mirror facets in each case separately from one another as mirror facets and bottom facets. In this case, the mirror facets acquire a polished surface and are arranged on a basic body by means of a bottom facet. In this case, the angular orientation of the polished surface with respect to a reference area of the basic body is predetermined and the required accuracy of the angular orientation can be achieved by firstly performing a measurement of the angular orientation of a mirror facet and subsequently providing a matching bottom facet.

In this case, the matching bottom facet can be selected from a plurality of prefabricated bottom facets by means of an angle measurement or be fabricated in a manner adapted to the geometry of the mirror facet.

In particular, the bottom facets and the mirror facets can be connected to one another to form overall facets by means of a bonding method.

There is likewise the possibility of connecting the bottom facets to the basic body by means of a bonding method.

The overall facets can be connected to form blocks by means of a bonding method, in particular, prior to mounting on the basic body. In this case, the angular orientation of the polished surfaces of the mirror facets can be measured after the overall facets have been connected to form blocks.

It is advantageous if that area of the bottom facet which faces the mirror facet contains a larger area than that area of the mirror facet which faces the bottom facet.

For the basic body it is possible to choose the same material as for the mirror or bottom facet, which can in particular also be formed in arcuate fashion. In particular, the basic body, the mirror facet or the bottom facet can contain silicon.

The mirror facet can have a thickness of less than 2 mm, in particular within the range of 0.2 mm-1.2 mm.

In particular, the mirror facet can be composed of an optically polishable material in which a surface roughness of less than 0.5 nm rms, preferably less than 0.2 nm rms, can be achieved in the high spatial frequency (HSFR) range, and the bottom facet can be composed of a material having a thermal conductivity of at least 100W/(mK), in particular a metallic material.

Cavities, in particular in the form of grooves, can be formed in the region between the mirror facet and the bottom facet, which can be connected to coolant lines.

The method enables the production of facet mirrors to be simplified considerably and thus to be made less expensive.

Exemplary embodiments of the invention are explained in more detail below with reference to the drawing.

In the figures:
- *figure 1*: shows a facet mirror in a projection exposure apparatus with an illumination system,
- figure 2: shows the principle of the invention using the example of a perspective illustration of an excerpt from a facet mirror according to the invention,
- figure 3: shows a perspective illustration of the basic body according to the invention,
- figure 4: shows, in subfigures 4a and 4b, variants for the configuration of the basic body with bearing areas and mirror facets,
- figure 5: shows an alternative embodiment of the invention,
- figure 6: shows an embodiment of the invention in which cutouts, in particular grooves, are arranged in the region of the contact area between the mirror facet and the carrying element,
- figure 7: shows an alternative to the solution illustrated in figure 6,
- figure 8: shows a variant of the invention in which the solution according to the invention is applied for a monolithic mirror, for example of an EUV projection exposure system,
- figure 9: shows a facet mirror with a basic body and overall facets arranged thereon,
- figure 10: shows a variant of the invention in which the overall facet is formed from a mirror facet and a bottom facet,
- figure 11: shows the distribution of the angles of the surfaces of the mirror and bottom facets,
- figure 12: shows the arrangement of the mirror facets on a polishing carrying body in figure part 12a in a plan view and in figure part 12b as a cross-sectional illustration,

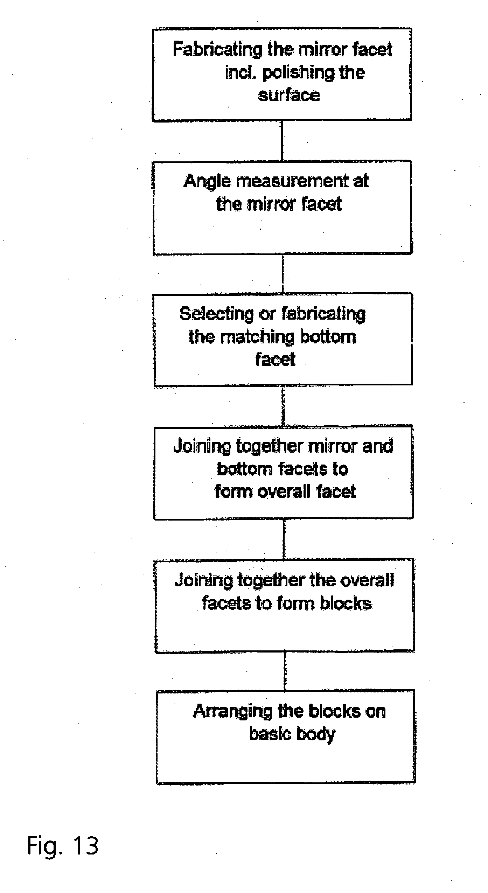

- figure 13: shows a self-explanatory flow diagram of the method variant ,
- figure 14: shows the geometrical properties of the mirror and bottom facets,
- figure 15: shows overall facets combined to form blocks,
- figure 16: shows the arrangement of the blocks of the overall facets on the basic body in a first viewing direction,
- figure 17: shows the arrangement of the blocks of the overall facets on the basic body in a second viewing direction, which is perpendicular to the first viewing direction.

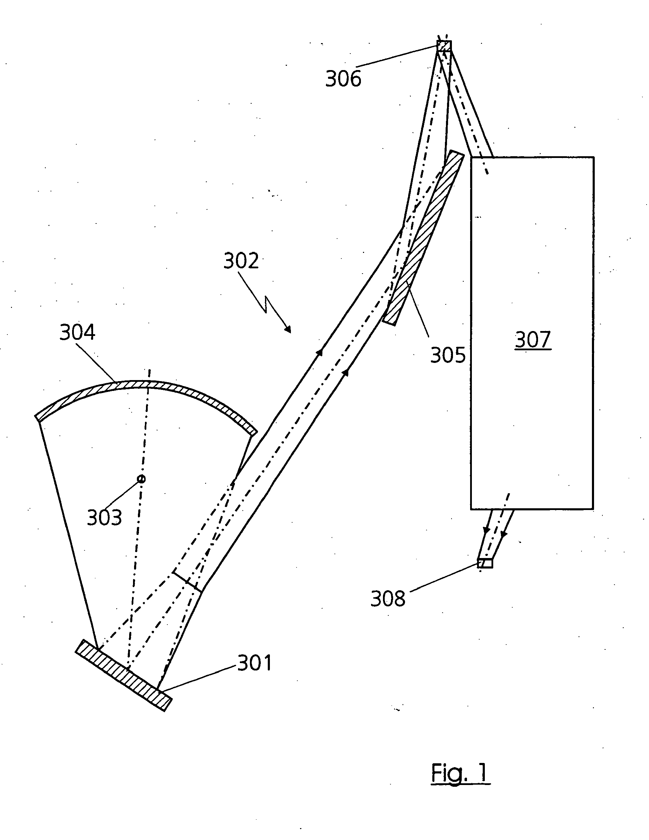

Figure 1 illustrates a facet mirror 301 in a projection exposure apparatus with an illumination system 302. The light from a light source 303, for example a plasma source, is deflected via a collector mirror 304 onto the facet mirror 301, from where it is fed with a desired uniform illumination via a deflection mirror 305 to a reticle 306. The pattern of the reticle 306 is transferred via a projection objective 307 (not illustrated in specific detail) with optical elements to a wafer 308 for highly demagnified imaging of the image of the reticle 306.

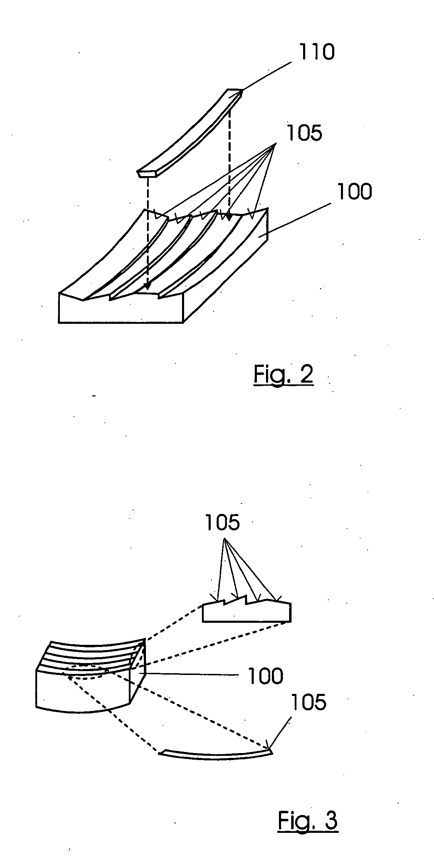

Figure 2 schematically shows the principle of the invention on the basis of the example of a perspective illustration of an excerpt from a facet mirror according to the invention. A plurality of bearing areas 105 each having different tilt angles are arranged on the basic body 100 of the facet mirror, the mirror facets 110 being applied to said areas in the arrow direction. It can be discerned from figure 2 that the mirror facets 110 are made comparatively thin with respect to the basic body 100; a typical thickness of the mirror facets according to the invention is approximately 1 mm. What is achieved by means of the configuration according to the invention of basic body 100 and mirror facet 110 is that the mirror facet 110, in the course of being joined on the basic body 100, can be adapted within certain limits to the surface shape and orientation of the bearing areas 105 on the basic body 100. In this way, fabrication-dictated shape deviations of the mirror facets 110 can be compensated for by the basic body 100. The mirror facet illustrated in figure 2. has a length of approximately 40-100mm and a width of approximately 1-10mm.

Figure 3 shows for illustration purposes once again a perspective illustration of the basic body 100 according to the invention. Figure 3 reveals that the bearing areas 105 can have different tilt angles or else different radii of curvature. The bearing areas 105 can in particular also be configured as freeform areas; it is likewise conceivable for the bearing areas 105 to exhibit a simpler geometry, for example planar geometry or else geometry in the shape of a lateral surface of a cylinder.

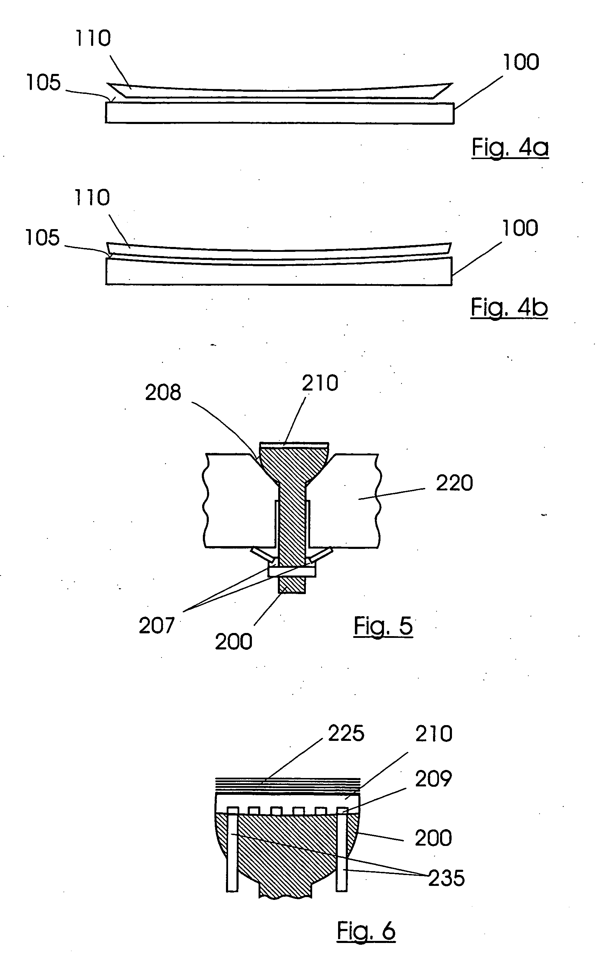

Figure 4 once again shows, in subfigures 4a and 4b, variants for the configuration of the basic body 100 with the bearing areas 105 and the mirror facets 110. Figure 4a illustrates the variant that the basic body 100 exhibits a planar bearing area 105, on which the mirror facet 110 is arranged by its likewise planar rear side. In contrast to this, figure 4b shows a basic body 100 having a curved bearing area 105, into which the likewise curved rear side of the mirror facet 110 is fitted.

Figure 5 shows an alternative embodiment of the invention. In this case, the mirror element formed as a mirror facet 210 is arranged on the stamp-type carrying element 200. In this case, the carrying element 200 is mounted on the carrier body 220 and can be tilted together with the mirror facet 210 with respect to the carrier body 220 by means of the schematically illustrated actuator system 207. In this case, in the present exemplary embodiment, both the carrier body 220 and the carrying element 200 are formed from steel. Furthermore, the bearing area 208 of the carrying element 200 on the carrier body 220 is worked mechanically with high precision, thereby ensuring a good thermal contact and mobility of the carrying element 200 in the carrier body 220 with the least possible friction. This ensures, inter alia, that the heat input into the mirror facet 210 on account of the incident EUV radiation can be efficiently dissipated via the carrying element 200 into the carrier body 220. In contrast to the material of the carrier body 220 and of the carrying element 200 that is chosen optimally with regard to mechanical processability and thermal conductivity, the material of the mirror facet 210 is optimized so as to result in a good surface polishability and hence a high reflectivity. In the present example, the mirror facet 210 is composed of silicon connected to the carrying element 200 by means of a soldering layer based on indium, for example, said soldering layer not being illustrated in figure 4. Since the silicon of the mirror facet 210 and the steel of the carrying element 200 have a mutually different coefficient of thermal expansion, it may be advantageous to avoid the resultant problem by means of the measure illustrated in figure 5.

Figure 6 shows an embodiment of the invention in which cutouts, in particular grooves 209, are arranged in the region of the contact area between the mirror facet 210 and the carrying element 200. Said grooves 209 have the advantage that the stresses and associated expansions that accompany heating with different coefficients of thermal expansion affect the reflective surface of the mirror facet 210 to a lesser extent and therefore impair the optical quality of the mirror facet 210 to a lesser extent than would be the case with a whole-area connection between mirror facet 210 and carrying element 200. The groove-type cutouts 209 illustrated furthermore afford the option of allowing a coolant such as water, for example, to flow through them, whereby the thermal problem outlined is furthermore alleviated; the corresponding coolant lines 235 are indicated schematically. The solution illustrated in figure 6 therefore extends the spectrum of materials that are appropriate for the mirror facet 210 and the carrying element 200, since the coefficients of thermal expansion of the materials used are permitted to deviate from one another in a larger range. For further illustration, the multilayer 225 arranged on the mirror facet 210 is illustrated purely schematically and not as true to scale in figure 6.

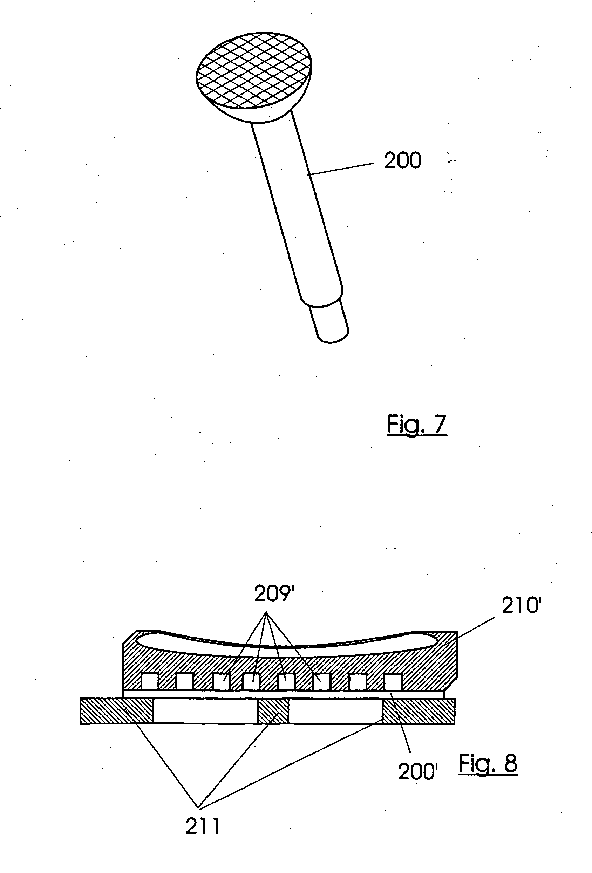

An alternative to the solution illustrated in figure 6 in which the groove-type cutouts 209 are worked from the mirror facet 210 is illustrated in figure 7; figure 7 shows in a perspective illustration a stamp-type carrying element 200, having a grid-type groove structure worked into its surface facing the mirror facet (not illustrated).

The variants illustrated in figures 2 to 7 concern mirror facets for facet mirrors which can comprise hundreds of said mirror facets. By contrast, figure 8 shows a variant of the invention in which the solution according to the invention is applied for a monolithic mirror, for example of an EUV projection exposure system. In this case, the mirror element 210' is formed as a monolithic silicon element having a polished surface, said element being applied on the carrying element 200' formed from steel. In this case, too, groove-type cutouts 209' are worked from the mirror element 210' on the rear side and coolant can likewise flow through them. The carrying element 200' with the mirror element 210' is arranged on the bearing elements 211. The mirror illustrated in figure 7 can not only be used in applications for EUV lithography but it is likewise also suitable for astronomical telescopes.

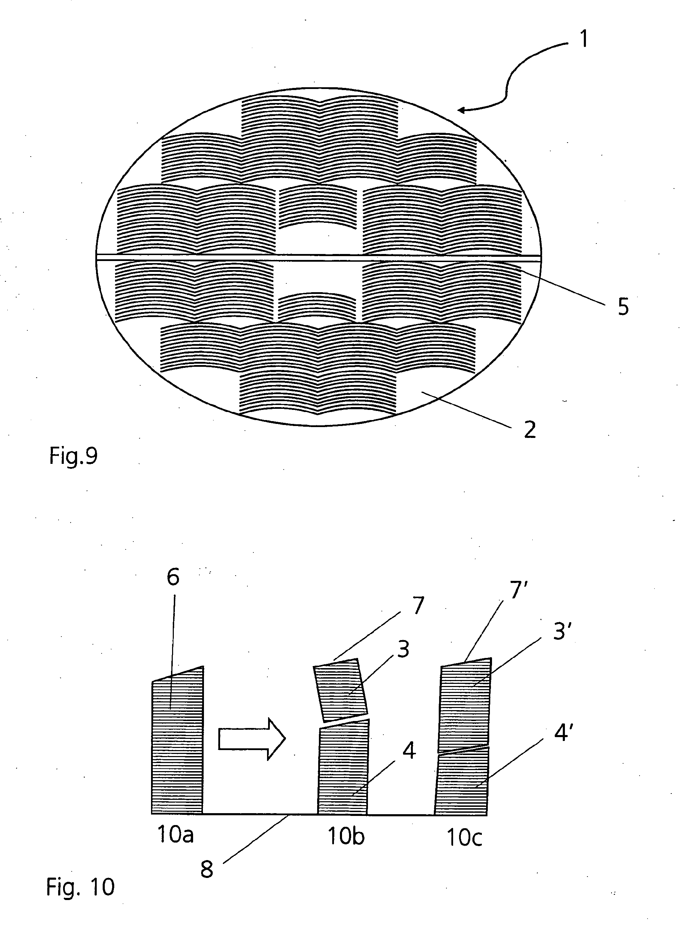

For illustrating the geometrical relationships of a further variant of the invention, figure 9 shows a facet mirror 1 with a basic body 2 and overall facets 5 arranged thereon. In this case, the overall facets 5 are formed in arcuate fashion and arranged in groups on the basic body 2 of the facet mirror 1. In this case, hundreds of overall facets 5 can be fitted on the basic body 2; approximately 300 overall facets 5 are shown in the example illustrated in figure 1.

Figure 10 illustrates the basic principle of the variant of the invention discussed. In contrast to the monolithically produced integral overall facet 6 according to the prior art, which is illustrated in figure part 10a on the left, according to the teaching of the invention the overall facet 5 is formed from a mirror facet 3 and a bottom facet 4 or a mirror facet 3' and a bottom facet 4'. Subfigure 10b illustrates a first variant regarding how a predetermined angle can be set between the polished surface 7 at the reference area of the basic body 8. In this case, the mirror facet 3 is realized essentially with a rectangular cross section and the area facing the mirror facet 3 is oriented with the desired angle with respect to the reference area of the basic body 8. As an alternative it is also possible, as illustrated in subfigure 10c, to form the mirror facet 3' with a cross section corresponding to a parallelogram. In this case, too, it is possible to achieve a correct orientation of the polished surface 7' with respect to the reference area of the basic body 8.

In the example shown in figure 10, the polished surface 7 or 7' of the mirror facet 3 or 3', respectively, has the required surface roughness. Owing to the method, that surface of the mirror facet 3 or 3' which faces the bottom facet 4 or 4', respectively, cannot be configured with a sufficiently accurate orientation with regard to its angle. According to the teaching of the present invention, the desired orientation of the polished surface 7 or 7' with respect to the reference area of the basic body 8 is now achieved by providing, i.e. either fabricating or selecting, the bottom facet 4 or 4', respectively, in a suitable manner. In this case, the two surfaces of the bottom facet and of the mirror facet which face one another can be plane and planar or else spherical; the bottom facet 4 or 4' and/or the mirror facet 3 or 3', respectively, can be composed of silicon.

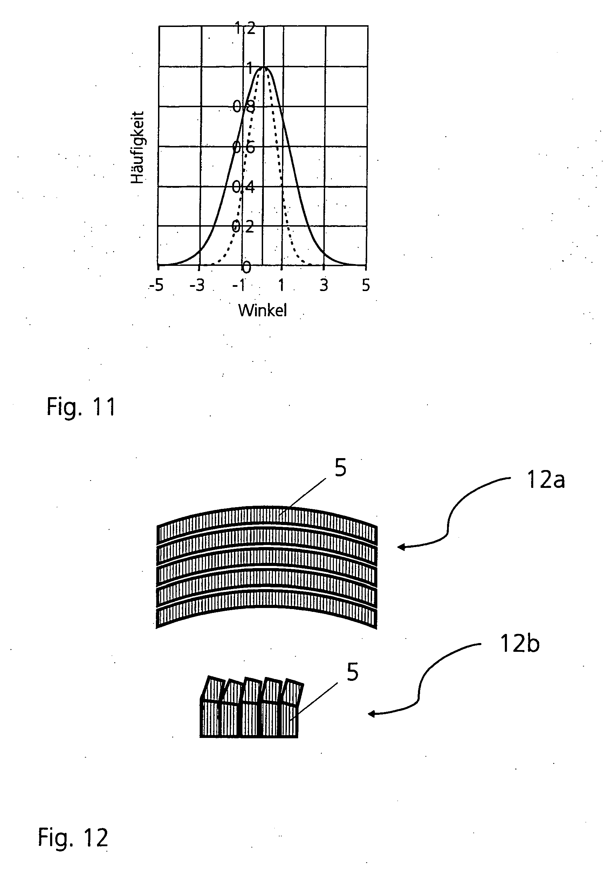

During the fabrication of the bottom facets 4 and 4' and the mirror facets 3 and 3', respectively, the angles of the finally processed areas vary in Gaussian fashion around a desired angle in the case where a relatively large number of facets are fabricated. The corresponding distribution of the angles of the surfaces is illustrated schematically in figure 11. In this case; the solid curve indicates the variation of the angles of the surface of the bottom facet, while the dashed curve indicates the angular distribution of the surface of the mirror facet. The distributions ideally lie one above another. In this case there is the possibility of finding, for example for a mirror facet whose surface has an angle that deviates by a specific magnitude from the desired angle set (in the region of the axis of symmetry of the curve), a bottom facet which precisely compensates for this error such that a correct orientation of the polished surface 7 or 7' with respect to the reference area 8 of the basic body is produced as a result. Therefore, firstly the angular orientation of the polished surface 7 or 7' of the mirror facet 3 or 3', respectively, is measured and afterward the matching bottom facet 4 or 4', respectively, is likewise selected by means of an angle measurement. Consequently, the errors originating from inaccuracies in fabrication can be compensated for just through skilful selection of the two facets to be connected. It is advantageous if the mirror facets 3 and 3' are produced in a higher number than the bottom facets 4 and 4', respectively; this effectively avoids a situation in which possibly no pairs can be assembled for individual desired overall facets with the correct angular orientation of the reflective surface 7. In the case of fabricating facets for a plurality of facet mirrors it is necessary anyway to provide a very high number of mirror facets 3 and 3' and bottom facets 4 and 4', respectively, beforehand, such that special fabrications are not necessary.

In this case, the polished surfaces 7 of the mirror facets 3 and 3' can be produced by a comparatively large mirror being polished and the arcuate mirror facets being cut out from the mirror by means of erosion. As an alternative, finished cut-to-size arcuate facets can be arranged in densely packed fashion on a polishing carrying body and subsequently be polished jointly; this method affords the advantage that it is considerably more cost-effective than the method described previously. Figure 12 shows the arrangement of the mirror facets 3 on the polishing carrying body in figure part 12a in a plan view and in figure part 12b as a cross-sectional illustration.

An alternative to the procedure outlined above consists in firstly selecting a mirror facet 3 or 3' and accurately measuring it with regard to its angular orientation. It is then possible to define the angles with which the surfaces of the associated bottom facet 4 or 4', respectively, have to be fabricated in order to ensure a correct orientation of the polished surface 7 with respect to the reference area of the basic body 8 as a result. The bottom facet 4 or 4' can then be ground with an accuracy of a few tens of seconds in such a way as to produce the matching angle.

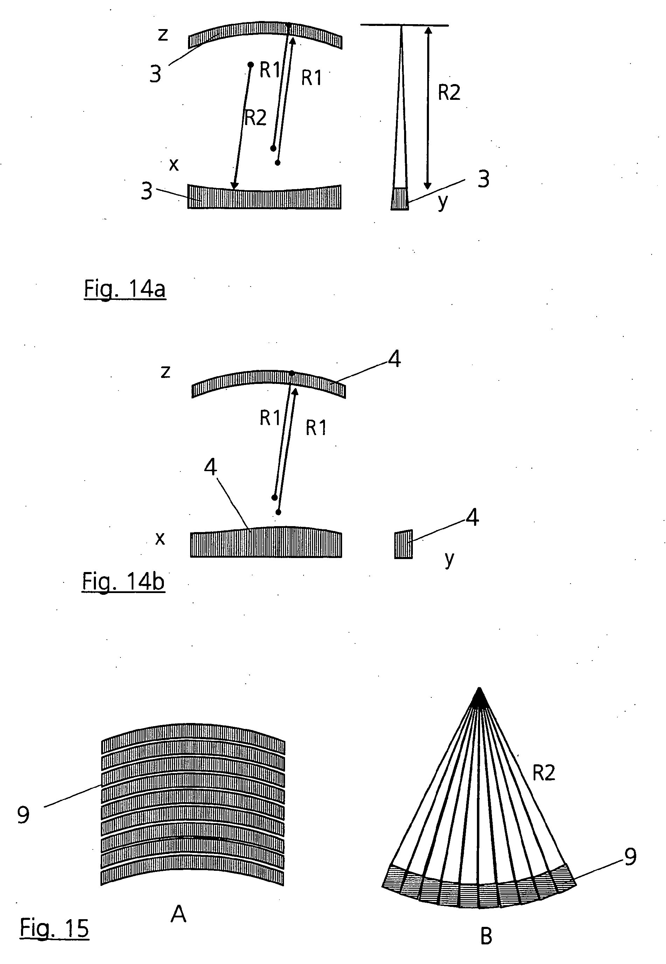

For further illustration, figure 14 illustrates the geometrical properties of the mirror and bottom facets 3 and 4, respectively. In this case, figure 14a shows a mirror facet 3 and figure 14b shows a bottom facet 4 in each case from x, y and z directions with the corresponding radii R1 and respectively R2 of curvature.

After the pairs of mirror and bottom facets 3, 3', 4, 4' have been provided, these are combined to form overall facets using a bonding method. Such methods can be used very well for crystals such as silicon, in particular; this results in a very fixed, permanent connection having good thermal conductivity. The mirror facets can be coated prior to being combined to form overall facets or else at some other suitable point in time in the process. The overall facets are then combined to form blocks 9, as are illustrated in figure 15. These blocks can also be discerned arranged on the basic body 2 in figure 1. Figure 15 shows the blocks 9 in a plan view in the left-hand part of the figure and in a cross-sectional illustration in the right-hand part of the figure. The bonding method can advantageously be used also for combining the overall facets 5 to form the blocks 9. In this case, the angles of the surfaces of the overall facets 5 of each block 9 are checked after mounting. Arranging the overall facets 5 to form blocks 9 affords the advantage that in the event of faults in the assembly, only the corresponding block 9 rather than the entire facet mirror is faulty. Gaps naturally remain between the overall facets 5 in the facet mirror since each overall facet 5 has its own predetermined angle. The dimensions of said gaps are within the range of a few tens of micrometers. However, this problem can be minimized by the optical design being suitably chosen by means of a corresponding selection of the angles of the overall facets that lie alongside one another. In order to ensure a good cohesion of the blocks 9 and a good thermal conductivity between the blocks 9, the bottom facets 4 and 4' are provided with somewhat larger dimensions than the mirror facets 3 and 3', respectively. In this way, no gaps remain between the bottom facets 4 and 4'. After the blocks 9 have been produced in accordance with the method described above, they are placed onto the reference area 8 of the basic body and either fixed there once again with the aid of a bonding method or else screwed there. In this case, the basic body is composed of the same material as the overall facets 5, that is to say of silicon in the present example.

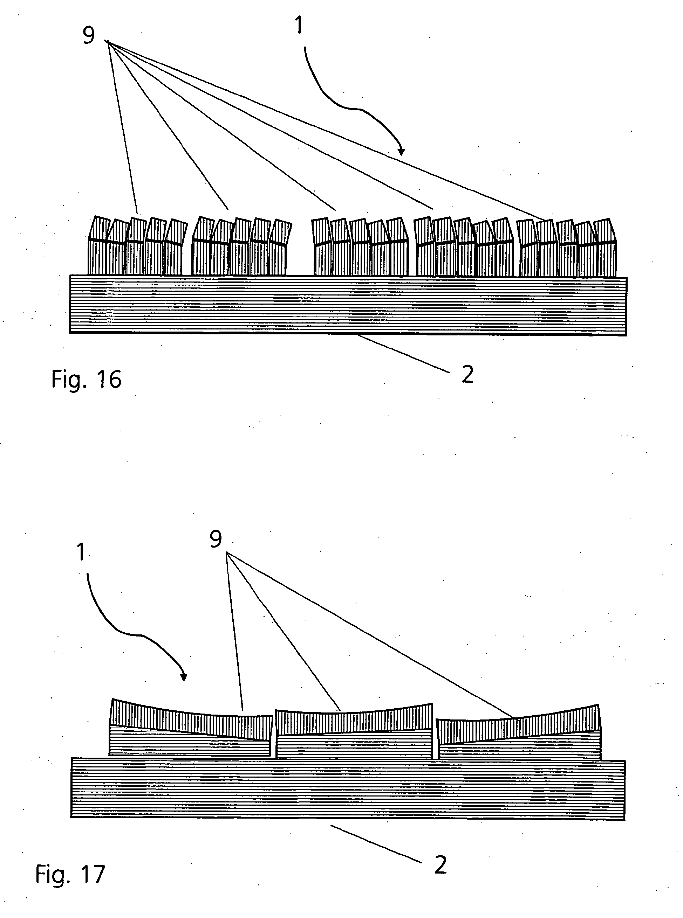

Figures 16 and 17 show, in a cross-sectional illustration, the arrangement of the blocks 9 of the overall facets 5 on the basic body 2 from two viewing directions that are perpendicular to one another.

The following clauses form part of the present description but are not claims, in accordance with Decision J15/88 of the European Patent Office Legal Board of Appeal.
(1) An EUV projection exposure apparatus, wherein the projection exposure apparatus has a facet mirror having mirror facets *(110)* arranged on carrying elements, characterized in that the mirror facets *(110)* have a thickness of less than 2 mm, in particular within the range of 0.2 mm-1.2 mm.
(2) The EUV projection exposure apparatus according to clause 1, characterized in that the mirror facets *(110)* are connected to the carrying elements by means of a soldering layer having a thickness within the range of 2 - 10 µm, in particular within the range of 3 - 7 µm.
(3) The EUV projection exposure apparatus according to clause 1, characterized in that the mirror facets *(110).* are connected to the carrying elements by means of an inorganic layer containing silicon oxide bridges.
(4) The EUV projection exposure apparatus according to clause 1, characterized in that the mirror facets *(110)* are connected to the carrying elements by means of a bonding or an adhesive layer.
(5) The EUV projection exposure apparatus according to one of clauses 1-4, characterized in that the mirror facets *(110)* have a reflective surface with a multilayer (225), in particular composed of Mo/Si double layers.
(6) The EUV projection exposure apparatus according to clause 5, characterized in that the multilayer (225) has approximately 10-80, in particular 50 double layers, wherein the thickness of the Mo/Si double layer is 6.8-15nm and wherein the thickness of the Mo layer is 1,3nm-12nm.
(7) The EUV projection exposure apparatus as according to either of clauses 5 and 6, characterized in that the total thickness of a double layer varies perpendicular to the layer course of the multilayer (225).
(8) The EUV projection exposure apparatus according to one of clauses 1-7, characterized in that the carrying element is formed as an intermediate piece, which for its part is arranged on a basic body (100).
(9) The EUV projection exposure apparatus according to one of clauses 1-8, characterized in that at least two mirror facets *(110)* are connected to a common, integral basic body (100) as carrying element.
(10) The EUV projection exposure apparatus according to clause 9, characterized in that the basic body (100) has differently oriented areas for receiving the mirror facets *(110)* or the intermediate pieces.
(11) The EUV projection exposure apparatus according to one of clauses 1-10, characterized in that all the mirror facets *(110)* of the facet mirror are arranged on a common, integral basic body (100).
(12) The EUV projection exposure apparatus according to one of clauses 9-11, characterized in that the basic body (100) is composed of the same material as the uncoated mirror facet *(110).*
(13) The EUV projection exposure apparatus according to one of clauses 9-12, characterized in that the basic body (100) is at least partly composed of Si.
(14) The EUV projection exposure apparatus according to one of clauses 1-11, characterized in that the mirror facet *(110)* is composed of an optically polishable material in which a surface roughness of less than 0.5 nm rms, preferably less than 0.2 nm rms, can be achieved in the high spatial frequency (HSFR) range, and in that the carrying element (200) is composed of a material having a thermal conductivity of at least 100W/(mK), in particular a metallic material.
(15) The EUV projection exposure apparatus according to one of clauses 1-14, characterized in that the mirror facets *(110)* contain Si, SiO₂, NiP, NiP-coated metal or SiC.
(16) The EUV projection exposure apparatus according to one of clauses 1-15, characterized in that the facet mirror is arranged in the illumination system of the EUV projection exposure apparatus.
(17) The EUV projection exposure apparatus according to one of clauses 1-16, characterized in that cavities, in particular in the form of grooves, are formed in the region between the mirror facet *(110)* and the carrying element (200).
(18) The EUV projection exposure apparatus according to clause 17, characterized in that the cavities are connected to coolant lines (235).
(19) An EUV projection exposure apparatus, wherein the projection exposure apparatus has at least one mirror element *(210)*, arranged on a carrying element (200), characterized in that the mirror element *(210)* is composed of an optically polishable material in which a surface roughness of less than 0.5 nm rms, preferably less than 0.2 nm rms, can be achieved in the high spatial frequency (HSFR) range, and in that the carrying element (200) is composed of a material having a thermal conductivity of at least 100W/(mK), in particular a metallic material.
(20) The EUV projection exposure apparatus according to clause 19, characterized in that the mirror element *(210)* is a mirror facet *(210)* formed as part of a facet mirror arranged in the illumination system of the apparatus.
(21) The EUV projection exposure apparatus according to either of clauses 19 and 20, characterized in that the mirror element *(210)* contains Si.
(22) The EUV projection exposure apparatus according to either of clauses 19 and 20, characterized in that the mirror element *(210)* is formed as a nickel-coated steel body.
(23) The EUV projection exposure apparatus according to one of clauses 19-22, characterized in that the mirror element *(210)* has a thickness within the range of 0.2-5 mm, preferably within the range of 1-3 mm.
(24) The EUV projection exposure apparatus according to one of clauses 19-23, characterized in that the carrying element (200) is arranged on a carrier body (220) and is embodied such that it is movable, in particular tiltable, with respect to the carrier body (220).
(25) The EUV projection exposure apparatus according to clause 24, characterized in that the carrying element (200) and the carrier body (220) are formed from the same material.
(26) The EUV projection exposure apparatus according to one of clauses 19-25, characterized in that the carrying element (200) is formed from Invar, Cu or Al.
(27) The EUV projection exposure apparatus according to one of clauses 19-26, characterized in that the mirror element *(210)* and the carrying element (200) are connected to one another by a soldering connection.
(28) The EUV projection exposure apparatus according to one of clauses 19-26, characterized in that the mirror element *(210)* is connected to the carrying element (200) by means of an inorganic layer containing silicon oxide bridges.
(29) The EUV projection exposure apparatus according to one of clauses 19-28, characterized in that cavities, in particular in the form of grooves, are formed in the region between the mirror element *(210)* and the carrying element (200).
(30) The EUV projection exposure apparatus according to clause 29, characterized in that the cavities are connected to coolant lines (235).
(31) The EUV projection exposure apparatus according to one of clauses 19-30, characterized in that the mirror element *(210)* is formed in wedge-shaped or spherical fashion.
(32) The EUV projection exposure apparatus according to one of clauses 19-30, characterized in that the mirror element *(210)* is a substantially circular lamina having a diameter within the range of between 2 mm-15 mm, preferably within the range of between 8 mm-12 mm.
(33) The EUV projection exposure apparatus according to one of clauses 19-32, characterized in that the mirror element (210) and the carrying element (200) are connected to one another by means of a connecting layer composed of a connecting material having a modulus of elasticity of < 70MPa.
(34) The EUV projection exposure apparatus according to one of clauses 19-33, characterized in that the mirror element *(210)* has a reflective surface with a multilayer (225), in particular composed of Mo/Si double layers.
(35) The EUV projection exposure apparatus according to clause 34, characterized in that the multilayer (225) has approximately 10-80, in particular 50 double layers, wherein the thickness of the Mo/Si double layer is 6.8-15nm and wherein the thickness of the Mo layer is 1,3nm-12nm.
(36) A method for producing overall facets (5) composed of mirror facets (3, 3') and bottom facets (4, 4') for a facet mirror, wherein mirror facets (3, 3') and bottom facets (4, 4') are in each case fabricated separately from one another, and wherein the mirror facets (3, 3') acquire at least one polished surface (7) and are arranged on a basic body (2) by means of the bottom facet (4, 4'), and wherein the angular orientation of the polished surface (7) with respect to a reference area (8) of the basic body (2) is predetermined, characterized in that in order to achieve the required accuracy of the angular orientation, a measurement of the angular orientation of a mirror facet (3, 3') is performed and a bottom facet (4, 4') is provided in such a way that after the mirror facet (3, 3') has been connected to the bottom facet (4, 4') the predetermined angular orientation with respect to the reference area (8) of the basic body (2) is achieved with a predetermined accuracy.
(37) The method according to clause 36, characterized in that the bottom facet (4, 4') is selected from a plurality of prefabricated bottom facets (4, 4') by means of an angular measurement.
(38) The method according to clause 36, characterized in that the bottom facet (4, 4') is fabricated in a manner adapted to the geometry of the mirror facet (3, 3').
(39) The method according to one of clauses 36-38, characterized in that the bottom facets (4, 4') and the mirror facets (3, 3') are connected to one another by means of a bonding method.
(40) The method according to one of clauses 36-39, characterized in that the bottom facets (4, 4') are connected to the basic body (2) by means of a bonding method.
(41) The method according to one of clauses 36-40, characterized in that the overall facets (5) are connected to form blocks (9) by means of a bonding method, in particular, prior to mounting on the basic body (2).
(42) The method according to clause 41, characterized in that a measurement of the angular orientation of the polished surfaces (7) of the mirror facets (3, 3') is performed after the overall facets (5) have been connected to form blocks (9).
(43) The method according to one of clauses 36-42, characterized in that that area of the bottom facet (4, 4') which faces the mirror facet (3, 3') contains a larger area than that area of the mirror facet (3, 3') which faces the bottom facet (4, 4').
(44) The method according to one of clauses 36-43, characterized in that the basic body (2) is composed of the same material as the mirror facet (3, 3') or the bottom facet (4, 4').
(45) The method according to one of clauses 36-44, characterized in that the mirror facets (3, 3') are formed in arcuate fashion.
(46) The method according to one of clauses 36-45, characterized in that the basic body (2), the mirror facet (3, 3') or the bottom facet (4, 4') contain silicon.
(47) The method according to one of clauses 36-46, characterized in that the mirror facet has a thickness of less than 2 mm, in particular within the range of 0.2 mm-1.2 mm.
(48) The method according to one of clauses 36-47, characterized in that the mirror facet (3, 3') is composed of an optically polishable material in which a surface roughness of less than 0.5 nm rms, preferably less than 0.2 nm rms, can be achieved in the high spatial frequency (HSFR) range, and in that the bottom facet (4, 4') is composed of a material having a thermal conductivity of at least 100W/(mK), in particular a metallic material.
(49) The method according to one of clauses 36-48, characterized in that cavities, in particular in the form of grooves, are formed in the region between the mirror facet (3, 3') and the bottom facet (4, 4').
(50) The method according to clause 49, characterized in that the cavities are connected to coolant lines (235).

## Claims

1. An EUV projection exposure apparatus, wherein the projection exposure apparatus has at least one mirror element *(210),* arranged on a carrying element (200), wherein the mirror element *(210)* is composed of an optically polishable material in which a surface roughness of less than 0.5 nm rms, preferably less than 0.2 nm rms, can be achieved in the high spatial frequency (HSFR) range, and in that the carrying element (200) is composed of a material having a thermal conductivity of at least 100W/(mK), in particular a metallic material, and wherein the mirror element *(210)* has a thickness within the range of 0.2-5 mm, preferably within the range of 1-3 mm, **characterized in that** cavities, in particular in the form of grooves, are formed in the region between the mirror element *(210)* and the carrying element (200), wherin the cavities are connected to coolant lines (235).

2. The EUV projection exposure apparatus as claimed in claim 1, **characterized in that** the mirror element *(210)* is a mirror facet *(210)* formed as part of a facet mirror arranged in the illumination system of the apparatus.

3. The EUV projection exposure apparatus as claimed in either of claims 1 and 2, **characterized in that** the mirror element *(210)* contains Si.

4. The EUV projection exposure apparatus as claimed in either of claims 1 and 2, **characterized in that** the mirror element *(210)* is formed as a nickel-coated steel body.

5. The EUV projection exposure apparatus as claimed in one of claims 1-4, **characterized in that** the carrying element (200) is arranged on a carrier body (220) and is embodied such that it is movable, in particular tiltable, with respect to the carrier body (220).

6. The EUV projection exposure apparatus as claimed in claim 5, **characterized in that** the carrying element (200) and the carrier body (220) are formed from the same material.

7. The EUV projection exposure apparatus as claimed in one of claims 1-6, **characterized in that** the carrying element (200) is formed from Invar, Cu or Al.

8. The EUV projection exposure apparatus as claimed in one of claims 1-7, **characterized in that** the mirror element *(210)* and the carrying element (200) are connected to one another by a soldering connection.

9. The EUV projection exposure apparatus as claimed in one of claims 1-7, **characterized in that** the mirror element *(210)* is connected to the carrying element (200) by means of an inorganic layer containing silicon oxide bridges.

10. The EUV projection exposure apparatus as claimed in one of claims 1-9, **characterized in that** the mirror element *(210)* is formed in wedge-shaped or spherical fashion.

11. The EUV projection exposure apparatus as claimed in one of claims 1-10, **characterized in that** the mirror element *(210)* is a substantially circular lamina having a diameter within the range of between 2 mm-15 mm, preferably within the range of between 8 mm-12 mm.

12. The EUV projection exposure apparatus as claimed in one of claims 1-11, **characterized in that** the mirror element (210) and the carrying element (200) are connected to one another by means of a connecting layer composed of a connecting material having a modulus of elasticity of < 70MPa.

## Patentansprüche

1. EUV-Projektionsbelichtungsanlage, wobei die Projektionsbelichtungsanlage mindestens ein auf einem Tragelement (200) angeordnetes Spiegelelement (210) aufweist, wobei das Spiegelelement (210) aus einem optisch polierbaren Material besteht, bei welchem eine Oberflächenrauheit von kleiner als 0,5 nm rms, bevorzugt kleiner als 0,2 nm rs, in dem Bereich mit hoher Ortsfrequenz, (HSFR)-Bereich, erreichbar ist, und wobei das Tragelement (200) aus einem Material besteht, das eine thermische Leitfähigkeit von mindestens 100W/(mK) aufweist, insbesondere aus einem metallischen Material, und wobei das Spiegelelement (210) eine Dicke im Bereich von 0,2 - 5 mm bevorzugt im Bereich von 1 - 3 mm aufweist, **dadurch gekennzeichnet, dass** Hohlräume, insbesondere in Form von Rillen, in dem Bereich zwischen dem Spiegelelement (210) und dem Tragelement (200) gebildet sind, wobei die Hohlräume mit Kühlmittelleitungen (235) in Verbindung stehen.

2. EUV-Projektionsbelichtungsanlage nach Anspruch 1, **dadurch gekennzeichnet, dass** es sich bei dem Spiegelelement (210) um eine Spiegelfacette (210) handelt, die als Teil eines in dem Beleuchtungssystem der Anlage angeordneten Facettenspiegels ausgebildet ist.

3. EUV-Projektionsbelichtungsanlage nach Anspruch 1 oder 2, **dadurch gekennzeichnet, dass** das Spiegelelement (210) Si enthält.

4. EUV-Projektionsbelichtungsanlage nach Anspruch 1 oder 2, **dadurch gekennzeichnet, dass** das Spiegelelement (210) als nickelbeschichteter Stahlkörper ausgebildet ist.

5. EUV-Projektionsbelichtungsanlage nach einem der Ansprüche 1 - 4, **dadurch gekennzeichnet, dass** das Tragelement (200) auf einem Trägerkörper (220) angeordnet und so ausgebildet ist, dass es gegenüber dem Trägerkörper (220) beweglich, insbesondere verkippbar, ist.

6. EUV-Projektionsbelichtungsanlage nach Anspruch 5, **dadurch gekennzeichnet, dass** das Tragelement (200) und der Trägerkörper (220) aus demselben Material gebildet sind.

7. EUV-Projektionsbelichtungsanlage nach einem der Ansprüche 1 - 6, **dadurch gekennzeichnet, dass** das Tragelement (200) aus Invar, Cu oder Al gebildet ist.

8. EUV-Projektionsbelichtungsanlage nach einem der Ansprüche 1 - 7, **dadurch gekennzeichnet, dass** das Spiegelelement (210) und das Tragelement (200) durch eine Lötverbindung miteinander verbunden sind.

9. EUV-Projektionsbelichtungsanlage nach einem der Ansprüche 1 - 7, **dadurch gekennzeichnet, dass** das Spiegelelement (210) mittels einer anorganischen Schicht, die Siliciumoxidbrücken enthält, mit dem Tragelement (200) verbunden ist.

10. EUV-Projektionsbelichtungsanlage nach einem der Ansprüche 1 - 9, **dadurch gekennzeichnet, dass** das Spiegelelement (210) keilförmig oder sphärisch ausgebildet ist.

11. EUV-Projektionsbelichtungsanlage nach einem der Ansprüche 1 - 10, **dadurch gekennzeichnet, dass** das Spiegelelement (210) ein im wesentlichen kreisförmiges Plättchen mit einem Durchmesser im Bereich von 2 mm - 15 mm, bevorzugt im Bereich zwischen 8 mm - 12 mm, ausgebildet ist.

12. EUV-Projektionsbelichtungsanlage nach einem der Ansprüche 1 - 11, **dadurch gekennzeichnet, dass** das Spiegelelement (210) und das Tragelement (200) mittels einer Verbindungsschicht aus einem Verbindungsmaterial mit einem Elastizitätsmodul von < 70 MPa miteinander verbunden sind.

## Revendications

1. Appareil d'exposition pour projection EUV, l'appareil d'exposition pour projection comportant au moins un élément de miroir (210) monté sur un élément de support (200), où l'élément de miroir (210) est réalisé en un matériau poli optiquement pour lequel une rugosité de surface inférieure à 0.5nm rms, de préférence inférieure à 0.2 nm rms peut être obtenue dans le domaine de la haute fréquence spatiale (HSFR), et où l'élément de support (200) est constitué d'un matériau ayant une conductivité thermique d'au moins 100W/ (mK), en particulier un matériau métallique et où l'élément de miroir (210) a une épaisseur de l'ordre de 0.2-5 mm, de préférence de l'ordre de 1-3 mm, **caractérisé en ce que** des cavités, en particulier sous la forme de gorges sont formées dans la zone située entre l'élément de miroir (210) et l'élément de support (200), ces cavités étant connectées à des conduits de réfrigérant (235).

2. Appareil d'exposition pour projection EUV selon la revendication 1, **caractérisé en ce que** l'élément de miroir (210) est une facette de miroir (210) constitué d'une partie d'un miroir à facettes disposé dans le système d'éclairage de l'appareil.

3. Appareil d'exposition pour projection EUV selon l'une quelconque des revendications 1 et 2, **caractérisé en ce que** l'élément de miroir (210) contient du Si.

4. Appareil d'exposition pour projection EUV selon l'une quelconque des revendications 1 et 2, **caractérisé en ce que** l'élément de miroir (210) est constitué d'un corps en acier revêtu de nickel.

5. Appareil d'exposition pour projection EUV selon l'une quelconque des revendications 1-4, **caractérisé en ce que** l'élément de support (200) est monté sur un corps porteur (220) et est conçu pour être amovible, en particulier inclinable par rapport au corps porteur (220).

6. Appareil d'exposition pour projection EUV selon la revendication 5, **caractérisé en ce que** l'élément de support (200) et le corps porteur (220) sont réalisés avec le même matériau.

7. Appareil d'exposition pour projection EUV selon l'une quelconque des revendications 1-6, **caractérisé en ce que** l'élément de support (200) est réalisé en Invar, Cu ou Al.

8. Appareil d'exposition pour projection EUV selon l'une quelconque des revendications 1-7, **caractérisé en ce que** l'élément de miroir (210) et l'élément de support (200) sont couplés l'un à l'autre au moyen d'une soudure.

9. Appareil d'exposition pour projection EUV selon l'une quelconque des revendications 1-7, **caractérisé en ce que** l'élément de miroir (210) est couplé à l'élément de support (200) au moyen d'une couche de matériau non organique contenant des ponts d'oxyde de silicone.

10. Appareil d'exposition pour projection EUV selon l'une quelconque des revendications 1-9, **caractérisé en ce que** l'élément de miroir (210) est formé en coin ou de façon sphérique.

11. Appareil d'exposition pour projection EUV selon l'une quelconque des revendications 1-10, **caractérisé en ce que** l'élément de miroir (210) est une lamelle sensiblement circulaire ayant un diamètre de l'ordre de 2mm-15mm et de préférence de l'ordre de 8mm-12mm.

12. Appareil d'exposition pour projection EUV selon l'une quelconque des revendications 1-11, **caractérisé en ce que** l'élément de miroir (210) et l'élément de support (200) sont couplés entre eux au moyen d'une couche de liaison composée d'un matériau de couplage ayant un module d'élasticité de < 70MPa.
